# EUROPÄISCHE PATENTSCHRIFT

(11) **EP 3 870 981 B1**
(45) Veröffentlichungstag und Bekanntmachung des Hinweises auf die Patenterteilung: **08.01.2025**
(21) Anmeldenummer: 19786952.2
(22) Anmeldetag: 11.10.2019
(51) Int. Cl.: G01R 21/06, G01R 35/00, G01R 19/25, G01R 35/04

(54) **MESSGERAET**
MEASURING DEVICE
APPAREIL DE MESURE

(30) Priorität: 26.10.2018 BE 201805742
(43) Veröffentlichungstag der Anmeldung: 01.09.2021
(73) Patentinhaber: Phoenix Contact GmbH & Co. KG, 32825 Blomberg (DE)
(72) Erfinder: JANKOWSKI, Martin, 30926 Seelze (DE)
(74) Vertreter: Patentship Patentanwaltsgesellschaft mbH
(86) Internationale Anmeldenummer: PCT/EP2019/077570
(87) Internationale Veröffentlichungsnummer: WO 2020/083664

(56) Entgegenhaltungen:
- EP-A1- 2 557 703
- EP-A2- 1 970 720
- WO-A2-2013/038176
- WO-A2-98/17003
- DE-A1- 102014 111 758
- JP-A- H1 169 598
- US-A1- 2017 045 570

## Beschreibung

Die vorliegende Erfindung betrifft ein Messgerät zum Messen einer physikalischen Größe und ein Verfahren zum Testen eines Messgeräts.

Messgeräte können eingesetzt werden, um physikalische Größen zu messen. Beispielsweise werden Messgeräte eingesetzt, um eine elektrische Leistung in einem System zu messen, beispielsweise einem mehrphasigen Leitungssystem.

Ein solches Messgerät kann Fehlermeldungen ausgeben, wenn die gemessene physikalische Größe eine vorbestimmte Bedingung erfüllt. Zum Beispiel brechen Spannung oder Strom stark ein oder eine Frequenz eines elektrischen Signals variiert ungewöhnlich. Dies kann von dem Messgerät angezeigt werden.

Um ein solches Messgerät zu testen, wird üblicherweise eine Quelle verwendet, die die entsprechende physikalische Größe bereitstellt. Beispielsweise wird eine Quelle für elektrische Leistung verwendet, die einen elektrischen Strom und eine elektrische Spannung bereitstellt, um ein Messgerät zu testen, das einen elektrischen Strom bzw. eine elektrische Spannung messen kann.

Jedoch kann es aufwendig und teuer sein, eine solche entsprechende physikalische Größe bereitzustellen. Sind beispielsweise für eine Ladesäule im E-Mobility-Bereich von Fahrzeugen Ströme im Bereich von 500 A möglich, und sollen diese Ströme mit einem Messgerät gemessen werden, so ist zum Testen des Messgeräts ebenso eine Stromquelle nötig, die 500 A bereitstellt.

Die Druckschrift WO 2013 / 038176 A2 offenbart eine Strommessvorrichtung mit einer Messanordnung, die an eine mit einem Stromsignal beaufschlagte Last angeschaltet und ausgebildet ist, das Stromsignal der Last zu messen.

Die Druckschrift US 2017 / 045570 A1 offenbart ein Testgerät zum Testen eines intelligenten elektronischen Geräts eines Energiesystems.

Die Druckschrift WO 98 / 17003 A2 betrifft eine integrierte Schaltung, die einen A/D-Wandler und eine Testschaltung umfasst.

Die Druckschrift EP 1 970 720 A2 offenbart ein Halbleiterbauelement, welches einen Halbleiterchip mit einem Sensorelement zum Messen einer physikalischen Größe und mit einer Auswerteeinrichtung aufweist.

Die Druckschrift EP 2 557 703 A1 betrifft eine Halbleitervorrichtung und ein Verfahren zum Prüfer einer Halbleitervorrichtung sowie eine Übertragungsschaltung.

Die Druckschrift DE 10 2014 111 758 A1 beschreibt ein Verfahren zum Überprüfen eines Feldgerätes mit einer Messsignalverarbeitung.

Es ist eine Aufgabe der Erfindung, ein verbessertes Konzept zum Testen eines Messgeräts bereitzustellen.

Diese Aufgabe wird durch den Gegenstand der unabhängigen Ansprüche gelöst. Vorteilhafte Ausführungsformen der Erfindung sind Gegenstand der abhängigen Ansprüche, der Beschreibung sowie der beiliegenden Figuren.

Die Offenbarung basiert auf der Erkenntnis, dass ein Signalsynthesizer im Messgerät den Ausgang eines Analog-Digital-Wandlers imitiert, um der Verarbeitungseinheit einen Messeingang zu simulieren.

Die Aufgabe wird gemäß einem ersten Aspekt durch ein Messgerät zum Messen einer physikalischen Größe gelöst. Das Messgerät weist einen Wandler auf, der eingerichtet ist, eine an einem Messeingang anliegende Eingangsgröße in ein Messsignal zu wandeln und als Ausgangsgröße bereitzustellen. Das Messgerät weist eine Verarbeitungseinheit auf, die eingerichtet ist, die Ausgangsgröße des Wandlers zu verarbeiten. Das Messgerät weist einen Signalgenerator auf, der eingerichtet ist, basierend auf einer Vorgabe ein Testsignal zu erzeugen, das einer Ausgangsgröße des Wandlers zu einer der Vorgabe entsprechenden Eingangsgröße entspricht; wobei die Verarbeitungseinheit über ein Schaltelement entweder mit dem Wandler oder mit dem Signalgenerator verbindbar ist.

Der Wandler ist ein Analog-Digital-Wandler. Der Messeingang kann eine Buchse oder ein Stecker sein, an den Messfühler anschließbar sind. Über den Messeingang kann zum Messen der physikalischen Größe ein Eingangssignal erfasst werden. Das Eingangssignal, das an dem Messeingang erfasst wird, kann die Eingangsgröße des Wandlers sein. Der Wandler wandelt die Eingangsgröße in eine Ausgangsgröße. Die Ausgangsgröße ist hierbei das Messsignal, d. h. das Signal, das der Wandler an die Verarbeitungseinheit weiterleitet. Das Messsignal kann ein digitales Signal sein. Der Wandler kann eine Vorverarbeitung, wie beispielsweise eine Reduzierung einer Stromstärke, umfassen. Die Vorverarbeitung ist dem Wandler vorgeschaltet. Die Vorverarbeitung kann einen Sensor oder einen Stromwandler umfassen. Die physikalische Größe kann auch direkt in den Wandler geführt werden. Am Eingang des Wandlers liegt ein Signal in analoger Form an. Dieses Signal hat das Signal charakterisierende Eigenschaften.

Das Testen kann eine Demonstration oder eine Schulung umfassen. Beispielsweise kann zusätzlich zum Funktionstest des Messgeräts der Testmodus zur Demonstration einem Kunden vorgeführt oder zu einer Schulung von Personal genutzt werden. Dies kann die Benutzer genauer auf den Umgang mit dem Messgerät vorbereiten und so eine Sicherheit erhöhen, da weniger Fehlbedienungen vorkommen.

Die Verarbeitungseinheit kann eine integrierte Elektronik umfassen. Die Verarbeitungseinheit kann logische Bausteine umfassen. Die Verarbeitungseinheit ist eingerichtet, das Messsignal, das der Wandler bereitstellt, zu verarbeiten. Beispielsweise erzeugt die Verarbeitungseinheit aus der Ausgangsgröße des

Wandlers, d.h. aus dem Messsignal, ein Anzeigesignal, das auf einer Anzeige darstellbar ist. Die Verarbeitungseinheit kann das Messsignal evaluieren, d.h. bestimmen, ob Grenzwerte eingehalten sind, ungewöhnliche Bedingungen eintreffen oder andere Fehler auftreten.

Der Wandler erzeugt ein digitales Signal, dessen Informationsgehalt die Eigenschaften des Eingangssignals des Wandlers beschreibt. Der Signalgenerator erzeugt ein digitales Signal, dessen Informationsgehalt die Eigenschaften gemäß der Vorgabe beschreibt. Repräsentieren die Werte der Vorgabe das gleiche Signal, das am Eingang des Wandlers anliegt, so wären die Ausgangssignale des Wandlers und des Signalgenerators identisch, wenn beide gleichzeitig ein Ausgangssignal bereitstellen würden.

Der Signalgenerator kann ein Synthesizer sein. Der Signalgenerator kann eingerichtet sein, ein digitales elektrisches Signal zu erzeugen. Die Signalerzeugung ist abhängig von einer Vorgabe. Die Vorgabe kann ein oder mehrere Parameter umfassen, die zur Bestimmung und zur Erzeugung eines Testsignals notwendig sind. Die Vorgabe kann ganz oder teilweise aus einem Speicher ausgelesen werden, der in dem Messgerät angeordnet ist. So kann die Vorgabe aus einer externen Quelle, beispielsweise einem Computersystem lediglich eine Abänderung einzelner vorgegebener Parameter des Signals sein, das erzeugt werden soll. Die Vorgabe kann hierbei lediglich einen der mehreren Parameter, die nötig sind, ein Testsignal zu erzeugen, anpassen. Die Vorgabe kann vollständig von einer externen Quelle stammen. Hierbei kann auf den Speicher verzichtet werden. Die Vorgabe kann die Eigenschaften des Signals am Eingang des Wandlers repräsentieren. Das heißt, die Vorgabe stellt Werte bereit, die das am Wandler anliegende analoge Eingangssignal repräsentieren. Die Vorgabe umfasst die Parameter, die das Signal repräsentieren, das der Wandler am Eingang des Wandlers empfängt.

Das Schaltelement kann in Software oder physikalisch ausgebildet sein.

Beispielsweise kann der Signalgenerator und die Verarbeitungseinheit Teil eines Mikrocontrollers sein. Hierbei kann die Umschaltung innerhalb des Mikrocontrollers erfolgen, insbesondere Softwarebasiert. Hierbei kann ein Signaleingang der Verarbeitungseinheit umgeschaltet werden.

Das Testsignal, das der Signalgenerator erzeugt, entspricht einer Ausgangsgröße des Wandlers. Das heißt, würde der Wandler am Messeingang eine anliegende Eingangsgröße erfassen, diese Eingangsgröße in ein Messsignal wandeln und als Ausgangsgröße bereitstellen, so entspricht das Testsignal des Signalgenerators genau dieser bereitgestellten Ausgangsgröße, wenn die Vorgabe, die dem Signalgenerator bereitgestellt wird, genau das Signal beschreibt, das am Messeingang als Eingangsgröße des Wandlers anliegt.

Wird durch das Messgerät beispielsweise eine in Deutschland übliche Haushaltssteckdose vermessen, so kann an dem Messeingang als Eingangsgröße eine Spannung von 230 V und/oder ein Stromwert von 16 A anliegen. Hierbei handelt es sich um eine Wechselspannung mit 50 Hz. Der Wandler wandelt diese Messwerte in ein Messsignal oder mehrere Messignale um und stellt dieses Messsignal oder diese Messsignale als Ausgangsgröße bereit. Das Messgerät kann aus der Ausgangsgröße beispielsweise eine Anzeige bestimmen und kann so auf einer Anzeige als Spannungswert 230 V und als Stromwert 16 A darstellen. Das Messgerät kann ebenso weiter Verarbeitungsschritte durchführen und gegebenenfalls Ergebnisse und Warnungen ausgeben.

Wird das Messgerät im Testmodus betrieben, so kann dem Signalgenerator ein Spannungswert von 230 V, ein Stromwert von 16 A und eine Frequenz von 50 Hz als Vorgabe vorgegeben werden. Der Signalgenerator erzeugt dann ein künstliches Messsignal als Testsignal und simuliert auf diese Weise ein Ausgangssignal des Wandlers. Das Testsignal entspricht hierbei genau demjenigen Signal, das der Wandler der Verarbeitungseinheit bereitgestellt hat. Das Testsignal wird insbesondere direkt der Verarbeitungseinheit bereitgestellt. Das heißt, die Verarbeitungseinheit empfängt, wenn der Signalgenerator an einen Eingang der Verarbeitungseinheit angeschlossen ist, das gleiche Signal, das heißt ein Signal mit den gleichen Signaleigenschaften, wie das Signal, das vorher von dem Wandler ausgegeben wurde. Die Anzeige, die die Verarbeitungseinheit hierbei bereitstellt, das heißt der Ausgang der Verarbeitungseinheit, entspricht in diesem Fall genau dem Ausgang der Verarbeitungseinheit, wie wenn der Wandler an die Verarbeitungseinheit angeschlossen wird. Wird die Ausgabe der Verarbeitungseinheit auf einer Anzeige ausgegeben, so zeigt diese ebenso 230 V und 16 A an.

Die Vorgabe kann eine Spannung in Prozent oder Volt umfassen. Die Vorgabe kann einen Strom in Prozent oder Ampere umfassen. Die Vorgabe kann einen Phasenwinkel, eine Frequenz für alle Leitungen oder auch Oberwellen für Spannungen und Ströme umfassen. Die Vorgabe kann eine dynamische Veränderung umfassen. Hierbei kann nach dem Zufallsprinzip der entsprechende Wert innerhalb vorgegebener Grenzen variiert werden.

Hierbei ist vorteilhaft, dass keine genaue und teure Strom- oder Spannungsquelle bereitgestellt werden muss, die entsprechend Signale bereitstellen kann. Es genügt, dem Messgerät die Vorgaben einzuspeisen, die als Signal getestet werden sollen. Der Signalgenerator erzeugt dann intern in dem Messgerät ein Testsignal, das der Ausgangsgröße des Wandlers entspricht. Die Gerätefunktionen des Messgeräts können erhalten bleiben. Diese können einen Webserver, Modbus-Interface, Displayanzeige, Mittelwerte, Log-Funktionen, Grenzwertschalter, Fehlermeldungen und weitere analoge oder digitale Schnittstellen umfassen. Die vollständige Prozesskette kann erhalten bleiben und die Funktionen des Messgeräts können wie gehabt genutzt werden.

Gemäß einer Ausgestaltung ist das Messgerät eingerichtet, eine elektrische Größe zu messen. Hierdurch lassen sich ein Strom oder eine Spannung messen.

Gemäß einer Ausgestaltung weist das Messgerät sechs Messeingänge auf und ist eingerichtet, jeweils eine Spannung und einen Strom einer dreiphasigen Leitung zu messen; oder das Messgerät weist zwei Messeingänge auf und ist eingerichtet, jeweils eine Spannung und einen Strom einer einphasigen Leitung zu messen und wobei der Signalgenerator eingerichtet ist, zwei entsprechende Testsignale zu erzeugen. Hierbei ist der Signalgenerator eingerichtet, sechs entsprechende Testsignale zu erzeugen.

Bei dem Messgerät kann es sich um ein Messgerät handeln, mit dem ein mehrphasiges System gemessen werden kann. Insbesondere können drei Leitungen eines Mehrphasensystems gemessen werden. Soll die Leistung in jeder Phase des Systems gemessen werden, so sind sechs Messeingänge notwendig, ein Spannungseingang und ein Stromeingang zu jeder der Phasen. Intern kann dann die Verarbeitungseinheit des Messgeräts aus den Eingängen, die einer Leitung zugeordnet sind, die Leistung aus der Spannung und dem Strom berechnen. In diesem Fall stellt auch der Signalgenerator entsprechend sechs Ausgänge bereit, die jeweils einem Wandlerausgang entsprechen. Ebenso können weiter Werte gemessen werden, beispielsweise eine Energie, eine Verzerrung, insbesondere THD, oder anderes. Die Buchsen zum Anschließen von Messkabeln bzw. Messfühlern können von den hier genannten Messeingängen abweichen. Insbesondere kann ein Messeingang für eine Strommessung zwei Buchsen aufweisen. Ebenso kann das Messgerät weitere Buchsen für jeden Messeingang aufweisen. Bei Spannungswerten umfasst ein Messeingang zusätzlich einen Bezugspunkt. Für eine Strommessung umfasst ein Messeingang zwei Buchsen.

In einer Ausgestaltung ist das Messgerät an ein Computersystem anschließbar und eingerichtet, die Vorgabe für das Testsignal von dem Computersystem zu empfangen.

Das Computersystem kann ein PC, ein Laptop oder ein Smartphone sein. Das Computersystem kann über eine drahtlose Schnittstelle oder eine kabelgebundene Schnittstelle mit dem Messgerät verbunden sein. Die Eingabe der Vorgabe kann über das Computersystem benutzerfreundlich erfolgen und eine bekannte Datenübertragung nutzen, wodurch der Aufwand zur Eingabe der Vorgabe verringert wird.

In einer Ausgestaltung umfasst die Vorgabe eine Phase und/oder eine Frequenz und/oder eine Oberwelle und/oder eine Amplitude eines Signals. Hierbei ist der Signalgenerator eingerichtet, das Testsignal auf der Basis wenigstens eines dieser Parameter zu erzeugen. Die Frequenz kann für das gesamte System gelten, das von dem Messgerät gemessen wird. Pro Phase werden die resultierenden Effektivwerte der Grundwellen für jeweils Strom und Spannung vorgegeben. Zusätzlich kann noch der Phasenverschiebungswinkel für jede der Phasen vorgegeben werden.

Sollen nicht nur Sinusförmige Größen vorgegeben werden können optional noch die Oberwellen für jeweils Strom und Spannung und deren Winkel angegeben werden. Es können jeweils eine oder mehrere Oberwellen vorgegeben werden.

Der Signalgenerator ist dazu eingerichtet, ein Messsignal zu erzeugen. Das Testsignal kann Grundwerte aufweisen, die beispielsweise in einem Speicher des Messgeräts hinterlegt sind. Auf diese Weise kann der Signalgenerator auch dann ein Testsignal erzeugen, wenn nicht alle Parameter separat von extern vorgegeben sind. Durch die externe Eingabe, d. h. die Vorgabe, kann vorgegeben werden, welche Parameter das Testsignal abzubilden hat. Hierbei kann beispielsweise eine Phase und/oder eine Frequenz und/oder eine Oberwelle und/oder eine Amplitude des Testsignals bestimmt werden. Werden mehrere Vorgaben für ein Testsignal oder mehrere Testsignale eingegeben, beispielsweise um eine dreiphasige Leitung zu simulieren, so können beispielsweise die einzelnen Testsignale phasenverschoben erzeugt werden, um einem entsprechenden Messwert zu genügen. Ebenso kann eine Oberwelle eines Signals simuliert werden.

In einer Ausgestaltung umfasst das Schaltelement einen elektronischen Schalter. Hierbei ist das Messgerät eingerichtet, das Schaltelement in Abhängigkeit eines Steuersignals umzuschalten. Ein elektronischer Schalter kann hierbei in Software implementiert sein. Hierbei kann auf einen physikalischen Schalter verzichtet werden. Über das Schaltelement kann in einer Logik ein Signaleingang umgeschaltet werden. Beispielsweise in einem Mikrocontroller.

Ein Computersystem kann an das Messgerät angeschlossen sein. Durch das Computersystem kann umgeschaltet werden, dass das Messgerät von einem Messmodus in einen Testmodus überwechselt und der Eingang der Verarbeitungseinheit statt des Ausgangs des Wandlers mit dem Ausgang des Signalgenerators verbunden ist. Dies stellt eine sichere Umschaltung zur Verfügung, bei der ein versehentliches Umschalten eines Schalters nicht möglich ist.

In einer Ausgestaltung ist das Messgerät eingerichtet, zur Umschaltung des Schaltelements ein Sicherheitsmerkmal abzufragen, insbesondere ein Passwort und/oder eine elektronische Kennung.

Um ein falsches Umschalten des Messgeräts von dem Messmodus in den Testmodus zu verhindern, kann das Umschalten des Schaltelements geschützt sein. Hierbei kann ein Passwort, beispielsweise eine alphanumerische Zeichenfolge und/oder eine elektronische Kennung, beispielsweise ein Token oder ein elektronischer Ausweis, abgefragt werden.

In einer Ausgestaltung ist das Messgerät eingerichtet, über ein Modbus-Interface zu kommunizieren und die Vorgabe über den Modbus zu empfangen. Ein Modbus ist eine Schnittstelle, mit der auf speicherprogrammierbaren Steuerungen kommuniziert werden kann. Hierbei lässt sich das Messgerät einfach anschließen.

Das Messgerät umfasst eine Ausgabeschnittstelle, insbesondere eine Anzeige. Hierbei ist die Verarbeitungseinheit eingerichtet, die verarbeitete Ausgangsgröße über die Ausgabeschnittstelle auszugeben. Hierbei kann ein einfaches Ablesen der gemessenen Werte ermöglicht werden, wenn die Ausgabe über die Anzeige erfolgt. Ist das Messgerät im Testmodus, kann so das verarbeitete Testsignal angezeigt werden. Die Anzeige kann eine optische Anzeige oder ein anderes Interface umfassen.

In einer Ausgestaltung ist das Schaltelement in einen Mikrocontroller integriert. Dies hat den Vorteil, dass das Schaltelement günstig zu realisieren ist.

Gemäß einem zweiten Aspekt der Erfindung wird die Aufgabe durch ein Verfahren zum Testen eines Messgeräts gelöst. Das Verfahren umfasst:
Umschalten eines Schaltelements, um eine Verarbeitungseinheit des Messgeräts mit einem Signalgenerator des Messgeräts zu verbinden, wobei der Signalgenerator eingerichtet ist, ein Testsignal basierend auf einer Vorgabe zu erzeugen;
Empfangen der Vorgabe für das Testsignal an einem Steuereingang des Messgeräts; Ausgeben des Testsignals durch den Signalgenerator basierend auf der Vorgabe an die Verarbeitungseinheit;
Verarbeiten des ausgegebenen Testsignals durch die Verarbeitungseinheit; und Ausgeben des verarbeiteten Testsignals über eine Ausgabeschnittstelle des Messgerätes.

In einer Ausgestaltung umfasst das Verfahren das Ausgeben des verarbeiteten Testsignals an einer Anzeige.

Das Ausgeben des Testsignals umfasst ein Ausgeben eines Hinweises, dass die Ausgabe auf einem Testsignal beruht.

Dies kann die Sicherheit erhöhen, ein versehentliches Betreiben des Messgeräts im Testmodus zu verhindern.

In einer Ausgestaltung wird vor dem Schritt des Schaltens des Schaltelements eine Sicherheitsabfrage durchgeführt. Das Schaltelement wird nur dann auf den Signalgenerator geschaltet, wenn ein Ergebnis der Sicherheitsabfrage positiv ist.

Die Sicherheitsabfrage kann die Eingabe eines Passworts, insbesondere einer alphanumerischen Zeichenfolge, das Erfassen einer biometrischen Eingabe oder einer elektronischen Kennung, wie von einem Token oder einem elektronischen Ausweis, umfassen. Nur wenn bei dieser Sicherheitsabfrage festgestellt wird, dass das Sicherheitskriterium erfüllt wurde, d. h. wenn festgestellt wird, dass der Benutzer berechtigt ist, das Messgerät in den Testmodus zu schalten, wird das Messgerät auch in den Testmodus geschaltet.

In einer Ausgestaltung wird eine Anzeige zum Anzeigen der Schaltstellung des Schaltelements dann ausgegeben, wenn das Schaltelement den Signalgenerator mit der Verarbeitungseinheit verbindet.

Hierdurch kann die Schaltung des Messgeräts in den Testmodus angezeigt werden, unabhängig davon, ob ein Testsignal erzeugt wird oder nicht.

In einer Ausgestaltung umfasst das Verfahren ferner:
Schalten des Schaltelements von dem Signalgenerator zu dem Wandler, wenn vorher das Schaltelement so geschaltet war, dass der Signalgenerator mit der Verarbeitungseinheit verbunden wurde und eine vorbestimmte Zeitspanne abgelaufen ist. Dies stellt sicher, dass nicht vergessen wird, das Messgerät zurück in den Messmodus zu schalten.

Hierbei kann das Messgerät wieder in den Messmodus zurückgeschaltet werden. Eine Rückschaltung kann auch bei oder durch ein Rücksetzen oder einen Neustart des Messgeräts erfolgen.

Hierzu kann das Messgerät einen Timer aufweisen.

In einer Ausführung umfasst die Vorgabe eine Veränderung eines Parameters, um ein fehlerhaftes Signal zu repräsentieren. Die Vorgabe kann so bestimmt werden, dass sie ein Signal repräsentiert, das ein fehlerhaftes Verhalten aufweist. Auf diese Weise kann ein Fehler in einem Signal, das von dem Messgerät gemessen würde, simuliert werden. Ebenso kann die Reaktion des Messgeräts auf Signalfehler bestimmt werden. In einer Ausführung ist die Vorgabe fehlerhaft bereitgestellt. Dies kann ebenso zum Testen des Messgeräts verwendet werden.

Die Erfindung wird im Folgenden anhand von Ausführungsbeispielen und den Figuren erläutert. Es zeigen:
- Fig. 1: eine schematische Darstellung eines Messgeräts gemäß einem Ausführungsbeispiel;
- Fig. 2: eine schematische Darstellung einer Anordnung eines Messgeräts gemäß einem Ausführungsbeispiel; und
- Fig. 3: ein Flussdiagramm für ein Verfahren gemäß einem Ausführungsbeispiel.

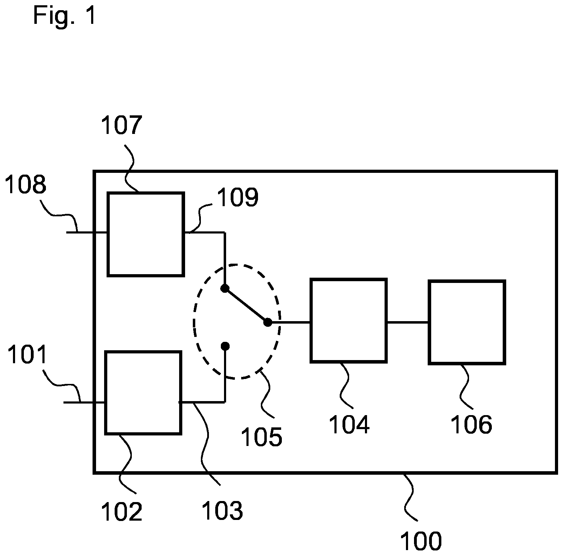

Fig. 1 zeigt ein Messgerät 100. Das Messgerät 100 weist einen Messeingang 101 auf. Der Messeingang 101 umfasst im beschriebenen Ausführungsbeispiel sechs Anschlüsse. In einem weiteren Ausführungsbeispiel umfasst der Messeingang 101 einen oder eine andere Anzahl Anschlüsse. Über die sechs Anschlüsse des Messeingangs 101 können drei Leitungen jeweils mit Strom und Spannung angeschlossen werden. Auf diese Weise lässt sich durch das Messgerät 100 eine dreiphasige Stromleitung messen, so dass das Messgerät 100 die Leistung einer jeden Phase einer dreiphasigen Leitung anzeigen kann. Ein Anschluss kann eine Mehrzahl an Buchsen umfassen. Insbesondere kann ein Stromanschluss, über den eine Strommessung möglich ist, zwei Buchsen umfassen.

Das Messgerät 100 ist ein Messgerät zum Messen einer elektrischen Leistung und weiterer aus den gemessenen Daten ableitbarer Werte, wie beispielsweise eine elektrische Energie. Ebenso können physikalische Größen direkt angezeigt werden, beispielsweise eine Spannung. In einem weiteren Ausführungsbeispiel ist das Messgerät 100 ein anderes Messgerät, beispielsweise zum Messen einer elektrischen Spannung, einer Temperatur oder einer räumlichen Distanz oder einer weiteren physikalischen Größe.

Das Messgerät 100 weist einen Wandler 102 auf. Der Wandler 102 ist ein Analog/Digital-Wandler. Der Wandler 102 wandelt eine Eingangsgröße, die an dem Messeingang 101 anliegt, in eine digitale Ausgangsgröße um. Der Wandler 102 stellt somit an einem Ausgang 103 des Wandlers eine Ausgangsgröße bereit. Die Ausgangsgröße ist ein Messsignal, das die gemessene physikalische Größe widerspiegelt. Der Wandler 102 umfass zusätzlich zu dem Analog/Digital-Wandler auch eine Vorverarbeitung (nicht dargestellt), um die gemessenen Signale vor dem zuführen in den Wandler 102 zu verarbeiten, insbesondere eine Konditionierung oder Transformierung des Signals vorzunehmen. Die der Wandler 102 mit der Vorverarbeitung kann ein analoges Frontend darstellen.

Das Messsignal, das heißt die Ausgangsgröße des Wandlers 102 an dem Ausgang 103 des Wandlers, kann durch eine Verarbeitungseinheit 104 des Messgeräts 100 verarbeitet werden. Hierzu ist die Verarbeitungseinheit 104 mit dem Ausgang 103 des Wandlers 102 elektrisch verbindbar. Hierfür ist zwischen der Verarbeitungseinheit 104 und dem Ausgang 103 des Wandlers 102 ein Schaltelement 105 angeordnet. Ist das Schaltelement 105 in einer ersten Schaltstellung, so ist der Ausgang 103 des Wandlers 102 mit einem Eingang der Verarbeitungseinheit 104 verbunden. An dem Eingang der Verarbeitungseinheit 104 liegt somit die Ausgangsgröße, d.h. das Messsignal, des Wandlers 102 an. Die Verarbeitungseinheit 104 interpretiert das Messsignal und errechnet gegebenenfalls hieraus weitere Wertparameter, die durch das Messgerät 100 erfasst werden sollen. Die Verarbeitungseinheit 104 kann aus dem Messsignal weitere physikalische Größen ableiten oder die physikalische Größe, die durch das Messsignal repräsentiert wird, mit Grenzwerten vergleichen und gegebenenfalls eine Fehlermeldung oder eine Warnung erzeugen.

Das Messgerät 100 weist eine Ausgabeschnittstelle 106 auf. Die Ausgabeschnittstelle 106 dient dazu, die Messwerte des Messgeräts 100 auszugeben, insbesondere umfasst die Ausgabeschnittstelle 106 eine Anzeige, um einem Benutzer die gemessene physikalische Größe darzustellen. Beispielsweise kann eine elektrische Spannung in Volt und ein elektrischer Strom in Ampere dargestellt werden. In weiteren Ausführungsbeispielen können entsprechende andere physikalischen Größen dargestellt werden. Die Verarbeitungseinheit 104 ist eingerichtet, das verarbeitete Messsignal an die Ausgabeschnittstelle 106 zu übertragen und so den von dem Messsignal im Messmodus gemessenen Wert auf der Ausgabeschnittstelle 106 darzustellen.

Das Messgerät 100 weist einen Signalgenerator 107 auf. Der Signalgenerator 107 ist mit einem Steuereingang 108 verbunden. Der Steuereingang 108 kann einem Kommunikationsstandard genügen, beispielsweise als Modbus-Interface ausgestaltet sein. Über den Steuereingang 108 kann dem Signalgenerator 107 eine Vorgabe gemacht werden. Die Vorgabe kann Werte einer physikalischen Größe umfassen. Beispielsweise kann ein Spannungswert auf 230 V festgelegt werden, insbesondere einen Effektivwert eines Spannungssignals auf 230 V festgelegt werden, und eine Stromstärke, d. h. einen Effektivwert eines Stroms auf 16 A festgelegt werden. Ebenso kann eine Frequenz eines Signals auf 50 Hz festgelegt werden, weitere Werte sind ebenso möglich. Es kann auch eine Oberwelle oder mehrere Oberwellen oder eine Phasenverschiebung festgelegt werden. Die Oberwelle kann einen Strom oder eine Spannung betreffen.

Der Signalgenerator 107 ist eingerichtet, ein Testsignal an einem Ausgang 109 des Signalgenerators 107 auszugeben. Das Testsignal simuliert hierbei das Messsignal des Wandlers 102. Das Testsignal stellt ein synthetisches Messsignal dar.

Mithilfe des Signalgenerators 107 und des Testsignals kann der Betrieb des Messgeräts 100 simuliert werden. Beispielsweise kann zu Demonstrations- oder Testzwecken überprüft werden, ob das Messgerät 100 auf bestimmte Signalveränderungen oder Signale reagiert.

In einer nicht dargestellten Schaltstellung ist das Schaltelement 105 in einer ersten Schaltposition und verbindet somit den Wandler 102 mit der Verarbeitungseinheit 104. Diese Stellung ist der Messbetrieb des Messgeräts 100. Über den Messeingang 101 kann eine physikalische Größe gemessen werden. Beispielsweise wird über den Messeingang 101 eine erste Spannung zu 231,2 V, eine zweite Spannung zu 230,9 V und eine dritte Spannung zu 229,8 V gemessen. Ebenso können über weitere Anschlüsse des Messeingangs 101 entsprechende Ströme gemessen werden. Der Wandler 102 wandelt diese gemessenen analogen Spannungswerte in digitale Signale um. Die digitalen Signale liegen als Ausgangsgröße bzw. als Messsignal an dem Ausgang 103 des Wandlers 102 an. Da das Messgerät 100 in dem Messbetrieb ist, liegen diese Signale auch an der Verarbeitungseinheit 104 an. Die Verarbeitungseinheit 104 kann aus den Werten, d. h. aus Spannung und Strom jeweils einer Phase einer dreiphasigen Leitung, die entsprechende Leistung berechnen, aber auch weitere Werte. Diese verarbeiteten Werte können über die Ausgabeschnittstelle 106 ausgegeben, insbesondere angezeigt, werden.

Soll nun getestet werden, ob das Messgerät 100 beispielsweise einen Spannungseinbruch an einer der Leitungen erkennen kann, so ist es nicht nötig, eine Leitung mit einer Spannung bereitzustellen und auf dieser Leitung dann einen Spannungseinbruch herbeizuführen.

Dank des Testmodus des Messgeräts 100 kann über das Schaltelement 105 das Messgerät 100 durch Schalten des Schaltelements 105 von dem ersten Schaltzustand in einen zweiten Schaltzustand in den Testmodus versetzt werden. Im Testmodus ist der Wandler 102 nicht mit der Verarbeitungseinheit 104 verbunden. Stattdessen ist der Signalgenerator 107 über den Ausgang 109 des Signalgenerators 107 mit dem Eingang der Verarbeitungseinheit 104 verbunden.

Über den Steuereingang 108 kann dem Signalgenerator 107 eine Vorgabe gemacht werden, ein Testsignal zu erzeugen, das der Wandler 102 erzeugt hätte, wenn am Messeingang 101 eine Eingangsgröße anläge, das von der Vorgabe abgebildet wird. Beispielsweise kann vorgegeben werden, dass ein Spannungssignal bei 231,2 V liegt und das nach ca. 10 s einen Spannungseinbruch um 95% erfährt. Die weiteren Werte entsprechen hierbei den üblichen Werten einer dreiphasigen Stromleitung. Diese können über den Steuereingang 108 vorgegeben werden oder werden von dem Signalgenerator 107 aus einem internen Speicher (nicht dargestellt) bereitgestellt. Der Signalgenerator 107 generiert nun ein Testsignal und arbeitet hierbei als Synthesizer. Der Signalgenerator 107 generiert das Testsignal so, dass für die Verarbeitungseinheit 104 kein Unterschied besteht zwischen einem gemessenen Signal, das der Wandler 102 in ein Messsignal umwandelt, und dem Testsignal des Signalgenerators 107. Die Verarbeitungseinheit 104 interpretiert hierbei das Testsignal als Ausgangsgröße des Wandlers 102. Die Verarbeitungseinheit 104 verarbeitet das Testsignal genauso wie die Ausgangsgröße des Wandlers 102, d. h. das Messsignal. Die Verarbeitungseinheit 104 gibt das Testsignal, d. h. den vermeintlich gemessenen Wert der physikalischen Größe, über die Ausgabeschnittstelle 106 aus. Nun kann abgelesen werden, dass der Spannungseinbruch korrekt angezeigt wird oder auch nicht, für den Fall, dass in der Verarbeitungseinheit 104 ein Fehler aufgetreten ist.

Das Testsignal kann zum Überprüfen der Funktionalität des Messgeräts 100 benutzt werden. Des Weiteren kann das Testsignal zu Schulungszwecken oder Demonstrationszwecken verwendet werden, um Benutzer in dem Umgang mit dem Messgerät 100 zu unterweisen.

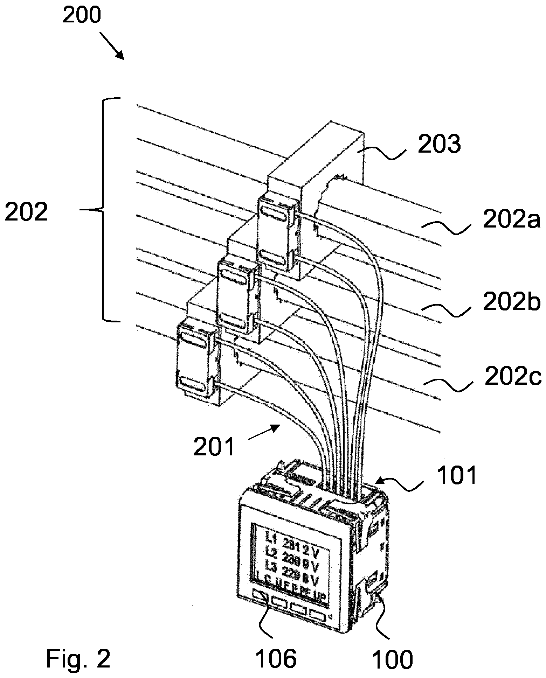

Fig. 2 zeigt eine Anordnung 200 mit dem Messgerät 100. An dem Messgerät 100 ist die Ausgabeschnittstelle 106 zu sehen. In das Messgerät 100 führen sechs Messleitungen 201, d.h. Messfühler, die mit dem Messeingang 101 des Messgeräts 100 verbunden sind. Die Messleitungen 201 sind hierbei an eine erste Phase 202a, eine zweite Phase 202b und eine dritte Phase 202c einer dreiphasigen elektrischen Leitung 202 angeschlossen. Jeweils zwei Anschlüsse des Messeingangs 101 sind an eine der Phasen 202a, 202b, 202c der elektrischen Leitung 202 angeschlossen, über einen Strommesswandler 203. Jeweils zwei Messleitungen 201 einer Phase 202a, 202b, 202c sind zum Messen eines Stroms eingerichtet. In weiteren Ausführungsbeispielen werden weitere Messleitungen 201 verwendet, um zusätzlich oder alternativ weitere Parameter, wie beispielsweise eine Spannung zu erfassen.

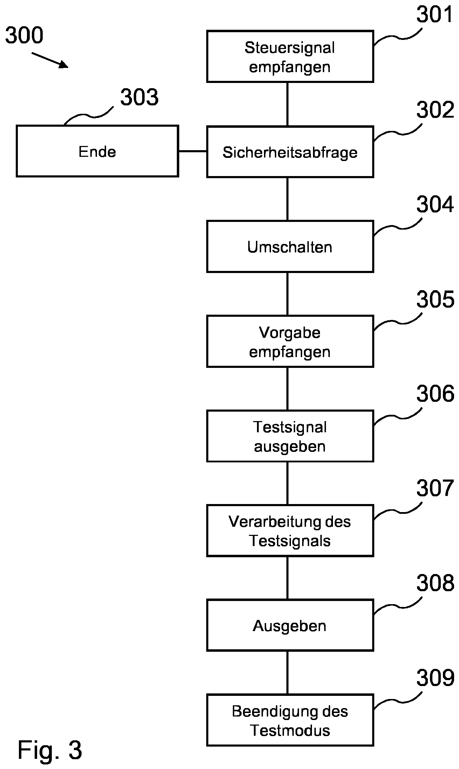

Fig. 3 zeigt ein Flussdiagramm 300 für ein Verfahren zum Testen eines Messgeräts 100 gemäß einem Ausführungsbeispiel.

In Schritt 301 empfängt das Messgerät 100 am Steuereingang 108 ein Steuersignal. Das Steuersignal zeigt an, dass eine Umschaltung des Schaltelements 105 von der ersten Schaltstellung in die zweite Schaltstellung stattfinden soll und das Messgerät 100 somit von dem Messbetrieb in einen Testbetrieb umschalten soll. Hierbei kann ein Administratormodus eingenommen werden. Dies kann einen Soft-Reset umfassen. Der Testmodus kann auch außerhalb des Administratormodus ausgeführt werden. Zur Umschaltung ist jedoch ein Administratormodus nötig. In einem weiteren Ausführungsbeispiel ist kein Administratormodus nötig.

Das Messgerät 100 initiiert hierauf eine Sicherheitsabfrage in Schritt 302. Hierbei wird ein Benutzer aufgefordert, über den Steuereingang 108 ein Passwort einzugeben. In einem weiteren Ausführungsbeispiel umfasst die Sicherheitsabfrage die Erfassung eines biometrischen Hinweises, einer elektronischen Kennung oder dergleichen. Ist die Sicherheitsabfrage negativ, d. h. wurde beispielsweise das Passwort falsch eingegeben oder kein Passwort eingegeben, so ist der Benutzer, der das Steuersignal 108 zum Umschalten in den Testmodus gesendet hat, nicht authentifiziert, und das Verfahren endet in Schritt 303. Die Umschaltung von der ersten Schaltstellung in die zweite Schaltstellung des Schaltelements 105 wird von dem Messgerät 10 nicht durchgeführt.

Ist das Ergebnis der Sicherheitsabfrage in Schritt 302 positiv, d. h. wurde der Benutzer korrekt authentifiziert, so findet in Schritt 304 ein Umschalten des Schaltelements 105 von dem ersten Schaltzustand in den zweiten Schaltzustand statt. Hierbei wird auf elektronische Weise das Schaltelement 105, hier eine interne Umschaltung eines Signaleingangs eines Mikrocontrollers, umgeschaltet. In einem weiteren Ausführungsbeispiel kann es sich hierbei um andere Schaltelemente handeln, wie beispielsweise einen Bipolartransistor. In einem weiteren Ausführungsbeispiel wird ein mechanischer Schaltweg freigegeben.

Mit dem Umschalten des Schaltelements 105 in den Testmodus, d. h. den zweiten Schaltzustand des Schaltelements 105, beginnt gleichzeitig ein Timer zu laufen. Der Timer misst die Zeit, d.h. die Dauer, für die das Schaltelement 105 in dem zweiten Schaltzustand ist. Unabhängig von weiteren Eingangssignalen schaltet das Schaltelement 105 nach Ablauf des Timers oder nach Erreichen einer vorbestimmten Zeit zurück in den ersten Schaltzustand. Dies kann als Sicherheit dienen, damit nicht vergessen wird, das Messgerät 100 in den Messbetrieb zurückzuschalten. In einem weiteren Ausführungsbeispiel findet diese automatische Zurückschaltung nicht statt. Hierbei kann auf einen Timer verzichtet werden.

In Schritt 305 wird eine Vorgabe empfangen. Die Vorgabe wird über den Steuereingang 108 dem Signalgenerator 107 bereitgestellt. Die Vorgabe umfasst hierbei Parameter, die ein elektrisches Signal beeinflussen und/oder bestimmen. Weitere notwendige Parameter zum Erzeugen eines solchen Signals sind entweder standardmäßig von einem Speicher vorgegeben oder müssen von dem Benutzer über den Steuereingang 108 eingegeben werden. Durch die Vorgabe sind die Eigenschaften eines elektrischen Signals bestimmbar. Insbesondere umfasst die Vorgabe eine Amplitude und/oder Frequenz und/oder Phase und/oder Oberwelle.

Durch die empfangene Vorgabe kann der Signalgenerator 107 in Schritt 306 das Testsignal ausgeben. Das Testsignal wird von dem Signalgenerator 107 hierbei über den Ausgang 109 des Signalgenerators 107 ausgegeben. Da das Schaltelement 105 in einem zweiten Schaltzustand ist, ist der Ausgang 109 des Signalgenerators 107 mit dem Eingang der Verarbeitungseinheit 104 verbunden. Somit liegt das Testsignal anstatt eines Messsignals nun an der Verarbeitungseinheit 104 an. Die Verarbeitungseinheit 104 interpretiert das Testsignal jedoch als Messsignal und verarbeitet dieses, als würde es von dem Wandler 102 stammen und eine tatsächlich gemessene physikalische Größe repräsentieren.

Die Verarbeitung der Verarbeitungseinheit 104 findet in Schritt 307 statt. Hierbei interpretiert die Verarbeitungseinheit 104 das Testsignal nach gewissen Vorgaben, beispielsweise wird hieraus eine Leistung oder ein anderer Wert errechnet.

In Schritt 308 stellt die Verarbeitungseinheit 104 der Ausgabeschnittstelle 106 eine Ausgabe bereit, um die Werte des Testsignals auf der Anzeige anzuzeigen oder anders auszugeben. Somit kann der Benutzer kontrollieren, ob die Anzeige den Erwartungen gemäß den eingespeisten Vorgaben entspricht. In einem weiteren Ausführungsbeispiel wird keine Ausgabe ausgegeben, wenn kein Fehler oder ein anderes vorbestimmtes Ereignis vorliegt.

In Schritt 309 erkennt das Messgerät 100, dass der Steuereingang 108 kein Signal mehr liefert. D. h., dass beispielsweise ein Stecker von dem Steuereingang 108 gezogen wurde. Hierauf schaltet das Schaltelement 105 zurück in den ersten Schaltzustand und setzt das Messgerät 100 wieder in den Messzustand.

In einem weiteren Ausführungsbeispiel findet dies nicht automatisch statt. Hierbei muss ein Benutzer das Messgerät 100 manuell zurückschalten. Hierzu muss er beispielsweise wieder über den Steuereingang 108 ein Steuersignal anlegen, um das Schaltelement 105 zurückzuschalten. Hierbei wird das Messgerät 100 aktiv zurückgeschaltete, beispielsweise über einen Reset oder einen Neustart.

Über die Ausgabeschnittstelle 106 kann zusätzlich angezeigt werden, dass sich das Messgerät 100 in dem Testmodus befindet. Diese Anzeige kann von der Schaltstellung des Schaltelements 105 abhängig sein. Des Weiteren kann angezeigt werden, dass die Anzeige auf einem Testsignal beruht.

### Bezugszeichenliste

- 100: Messgerät
- 101: Messeingang
- 102: Wandler
- 103: Ausgang
- 104: Verarbeitungseinheit
- 105: Schaltelement
- 106: Ausgabeschnittstelle
- 107: Signalgenerator
- 108: Steuereingang
- 109: Ausgang
- 200: Anordnung
- 201: Messleitung
- 202: dreiphasige Leitung
- 202a, 202b, 2102c: Phase
- 203: Strommesswandler
- 300: Flussdiagramm
- 301-309: Verfahrensschritt

## Patentansprüche

1. Messgerät (100) zum Messen einer physikalischen Größe mit:
einem A/D-Wandler (102), der eingerichtet ist, eine an einem Messeingang (101) anliegende Eingangsgröße in ein Messsignal zu wandeln und als Ausgangsgröße bereitzustellen;
einer Verarbeitungseinheit (104), die eingerichtet ist, die Ausgangsgröße des A/D-Wandlers (102) zu verarbeiten; und
einem Signalgenerator (107), der eingerichtet ist, basierend auf einer Vorgabe ein Testsignal zu erzeugen, das einer Ausgangsgröße des A/D-Wandlers (102) zu einer der Vorgabe entsprechenden Eingangsgröße entspricht;
wobei die Verarbeitungseinheit (104) über ein Schaltelement (105) entweder mit dem A/D-Wandler (102) oder mit dem Signalgenerator (107) verbindbar ist; wobei
das Messgerät (100) eine Ausgabeschnittstelle (106) umfasst und die Verarbeitungseinheit (104) eingerichtet ist, die verarbeitete Ausgangsgröße über die Ausgabeschnittstelle (106) auszugeben; und
wobei die Vorgabe ganz oder teilweise aus einem Speicher, welcher in dem Messgerät (100) angeordnet ist, auslesbar ist oder wobei die Vorgabe vollständig von einer externen Quelle stammt, **dadurch gekennzeichnet, dass**
der Signalgenerator (107) ausgebildet ist, das Testsignal mit einem Hinweis auszugeben, dass die Ausgabe auf einem Testsignal beruht.

2. Messgerät (100) nach Anspruch 1, wobei das Messgerät (100) eingerichtet ist, eine elektrische Größe zu messen.

3. Messgerät (100) nach Anspruch 2, wobei das Messgerät (100) sechs Messeingänge (101) aufweist und eingerichtet ist, jeweils eine Spannung und einen Strom einer dreiphasigen Leitung (202) zu messen und wobei der Signalgenerator (107) eingerichtet ist, sechs entsprechende Testsignale zu erzeugen; oder wobei das Messgerät (100) zwei Messeingänge (101) aufweist und eingerichtet ist, jeweils eine Spannung und einen Strom einer einphasigen Leitung (202) zu messen und wobei der Signalgenerator (107) eingerichtet ist, zwei entsprechende Testsignale zu erzeugen.

4. Messgerät (100) nach einem der vorstehenden Ansprüche, wobei das Messgerät (100) an ein Computersystem anschließbar ist und eingerichtet ist, die Vorgabe für das Testsignal von dem Computersystem zu empfangen.

5. Messgerät (100) nach einem der vorstehenden Ansprüche, wobei die Vorgabe eine Phasenverschiebung und/oder eine Frequenz und/oder eine Oberwelle und/oder einen Effektivwert eines Signals umfasst und wobei der Signalgenerator (107) eingerichtet ist, das Testsignal auf der Basis wenigstens eines dieser Parameter zu erzeugen.

6. Messgerät (100) nach einem der vorstehenden Ansprüche, wobei das Schaltelement (105) einen elektronischen Schalter umfasst und das Messgerät (100) eingerichtet ist, das Schaltelement (105) in Abhängigkeit eines Steuersignals umzuschalten.

7. Messgerät (100) nach Anspruch 6, wobei das Messgerät (100) eingerichtet ist, zur Umschaltung des Schaltelements (105) ein Sicherheitsmerkmal abzufragen, insbesondere ein Passwort und/oder eine elektronische Kennung.

8. Messgerät (100) nach einem der vorstehenden Ansprüche, wobei das Messgerät (100) eingerichtet ist, über ein Modbus-Interface zu kommunizieren und die Vorgabe über den Modbus zu empfangen.

9. Messgerät (100) nach einem der vorstehenden Ansprüche, wobei das Schaltelement (105) einen Mikrocontroller oder einen Transistor, insbesondere einen MOSFET oder einen Bipolartransistor umfasst und ausgebildet ist, eine elektronische Umschaltung auszuführen.

10. Verfahren zum Testen eines Messgeräts (100) mit einem A/D-Wandler, umfassend:
Umschalten (304) eines Schaltelements (105), um eine Verarbeitungseinheit (104) des Messgeräts (100) mit einem Signalgenerator (107) des Messgeräts (100) zu verbinden, wobei der Signalgenerator (107) eingerichtet ist, ein Testsignal basierend auf einer Vorgabe zu erzeugen;
Empfangen (305) der Vorgabe für das Testsignal an einem Steuereingang (108) des Messgeräts (100);
Ausgeben (306) des Testsignals durch den Signalgenerator (107) basierend auf der Vorgabe an die Verarbeitungseinheit (104);
Verarbeiten (307) des ausgegebenen Testsignals durch die Verarbeitungseinheit (104),
Ausgeben der verarbeiteten Ausgangsgröße über eine Ausgabeschnittstelle (106) des Messgeräts (100);
wobei die Vorgabe ganz oder teilweise aus einem Speicher, welcher in dem Messgerät (100) angeordnet ist, auslesbar ist oder wobei die Vorgabe vollständig von einer externen Quelle stammt,
**gekennzeichnet dadurch, dass**
das Ausgeben (306) des Testsignals ein Ausgeben eines Hinweises umfasst, dass die Ausgabe auf einem Testsignal beruht.

11. Verfahren nach Anspruch 10, ferner umfassend:
Ausgeben (308) des verarbeiteten Testsignals über eine Ausgabeschnittstelle (106) des Messgeräts (100).

12. Verfahren nach Anspruch 10 oder 11, wobei vor dem Schritt des Umschaltens (304) des Schaltelements (105) eine Sicherheitsabfrage durchgeführt wird (302), und das Schaltelement (105) nur dann auf den Signalgenerator (107) geschaltet wird, wenn ein Ergebnis der Sicherheitsabfrage (302) positiv ist.

13. Verfahren nach einem der Ansprüche 10 bis 12, wobei eine Anzeige zum Anzeigen der Schaltstellung des Schaltelements (105) dann ausgegeben wird, wenn das Schaltelement (105) den Signalgenerator (107) mit der Verarbeitungseinheit (104) verbindet.

14. Verfahren, nach einem der Ansprüche 10 bis 13, wobei die Vorgabe eine Veränderung eines Parameters umfasst, um ein fehlerhaftes Signal zu repräsentieren.

## Claims

1. Measuring device (100) for measuring a physical variable, comprising:
an A/D converter (102), which is configured to convert an input variable present at a measurement input (101) into a measurement signal and to provide the same as an output variable;
a processing unit (104), which is configured to process the output variable of the A/D converter (102); and
a signal generator (107), which is configured to generate a test signal on the basis of a specification, which test signal corresponds to an output variable of the A/D converter (102) associated to an input variable corresponding to the specification;
wherein the processing unit (104) can be connected via a switching element (105) either to the A/D converter (102) or to the signal generator (107),
wherein the measuring device (100) comprises an output interface (106) and the processing unit (104) is configured to output the processed output variable via the output interface (106); and
wherein the specification can be read completely or partially from a memory, which is arranged in the measuring device (100), or wherein the specification originates completely from an external source, **characterized in that**
the signal generator (107) is configured to output the test signal with an indication that the output is based on a test signal.

2. Measuring device (100) according to claim 1, wherein the measuring device (100) is configured to measure an electrical variable.

3. Measuring device (100) according to claim 2, wherein the measuring device (100) has six measurement inputs (101) and is configured to measure a voltage and a current of a three-phase line (202), respectively, and wherein the signal generator (107) is configured to generate six corresponding test signals; or wherein the measuring device (100) has two measurement inputs (101) and is configured to measure a voltage and a current of a single-phase line (202), respectively, and wherein the signal generator (107) is configured to generate two corresponding test signals.

4. Measuring device (100) according to any of the preceding claims, wherein the measuring device (100) can be connected to a computer system and is configured to receive the specification for the test signal from the computer system.

5. Measuring device (100) according to any of the preceding claims, wherein the specification comprises a phase shift and/or a frequency and/or a harmonic and/or an effective value of a signal and wherein the signal generator (107) is configured to generate the test signal on the basis of at least one of these parameters.

6. Measuring device (100) according to any of the preceding claims, wherein the switching element (105) comprises an electronic switch and the measuring device (100) is configured to switch the switching element (105) as a function of a control signal.

7. Measuring device (100) according to claim 6, wherein the measuring device (100) is configured to query a security feature, in particular a password and/or an electronic identifier, in order to switch the switching element (105).

8. Measuring device (100) according to any of the preceding claims, wherein the measuring device (100) is configured to communicate via a Modbus-interface and to receive the specification via the Modbus.

9. Measuring device (100) according to any of the preceding claims, wherein the switching element (105) comprises a microcontroller or a transistor, in particular a MOSFET or a bipolar transistor and is configured to perform an electronic switching.

10. A method for testing a measuring device (100) with an A/D converter, the method comprising:
switching (304) a switching element (105) in order to connect a processing unit (104) of the measuring device (100) to a signal generator (107) of the measuring device (100), wherein the signal generator (107) is configured to generate a test signal on the basis of a specification;
receiving (305) the specification for the test signal at a control input (108) of the measuring device (100);
outputting (306) the test signal by the signal generator (107) based on the specification to the processing unit (104); and
processing (307) the output test signal by the processing unit (104),
outputting the processed output variable via an output interface (106) of the measuring device (100);
wherein the specification can be read completely or partially from a memory, which is arranged in the measuring device (100), or wherein the specification originates completely from an external source,
**characterized in that**
the outputting (306) of the test signal comprises outputting an indication that the output is based on a test signal.

11. Method according to claim 10, further comprising:
outputting (308) the processed test signal via an output interface (106) of the measuring device (100).

12. Method according to any one of claims 10 or 11, wherein before the step of switching (304) the switching element (105), a security query is performed (302), and the switching element (105) is only switched to the signal generator (107) if a result of the security query (302) is positive.

13. Method according to any one of claims 10 to 12, wherein a display for displaying the switching position of the switching element (105) is output when the switching element (105) connects the signal generator (107) to the processing unit (104).

14. Method according to any one of claims 10 to 13, wherein the specification comprises a change in a parameter in order to represent an erroneous signal.

## Revendications

1. Dispositif de mesure (100) pour mesurer une grandeur physique avec :
un convertisseur analogique-numérique, A/N (102), qui est configurée pour convertir une variable d'entrée présente à une entrée de mesure (101) en un signal de mesure et pour fournir celui-ci en tant que variable de sortie ;
une unité de traitement (104), qui est configurée pour traiter la variable de sortie du convertisseur A/N (102) ; et
un générateur de signal (107), qui est configurée pour générer un signal de test sur la base d'une spécification, lequel signal de test correspond à une variable de sortie du convertisseur A/N (102) associée à une variable d'entrée correspondant à la spécification ;
dans lequel l'unité de traitement (104) peut être connectée via un élément de commutation (105) soit au convertisseur A/N (102) soit au générateur de signal (107),
dans lequel le dispositif de mesure (100) comprend une interface de sortie (106) et l'unité de traitement (104) est configurée pour délivrer en sortie la variable de sortie traitée via l'interface de sortie (106) ; et
dans lequel la spécification peut être lue complètement ou partiellement à partir d'une mémoire, qui est agencée en le dispositif de mesure (100), ou dans lequel la spécification provient entièrement d'une source externe, **caractérisé en ce que**
le générateur de signal (107) est configurée pour émettre le signal de test avec une indication que la sortie est basée sur un signal de test.

2. Dispositif de mesure (100) selon la revendication 1, dans lequel le dispositif de mesure (100) est configurée pour mesurer une grandeur électrique.

3. Dispositif de mesure (100) selon la revendication 2, dans lequel le dispositif de mesure (100) comporte six entrées de mesure (101) et est configurée pour mesurer respectivement une tension et un courant d'une ligne triphasée (202), et dans lequel le générateur de signaux (107) est configurée pour générer six signaux de test correspondants ; ou dans lequel le dispositif de mesure (100) comporte deux entrées de mesure (101) et est configurée pour mesurer respectivement une tension et un courant d'une ligne monophasée (202), et dans lequel le générateur de signaux (107) est configurée pour générer deux signaux de test correspondants.

4. Dispositif de mesure (100) selon l'une des revendications précédentes, dans lequel le dispositif de mesure (100) peut être connecté à un système informatique et est configurée pour recevoir la spécification du signal de test du système informatique.

5. Dispositif de mesure (100) selon l'une des revendications précédentes, dans lequel la spécification comprend un déphasage et/ou une fréquence et/ou une harmonique et/ou une valeur efficace d'un signal et dans lequel le générateur de signal (107) est configurée pour générer le signal de test sur la base d'au moins un de ces paramètres.

6. Dispositif de mesure (100) selon l'une des revendications précédentes, dans lequel l'élément de commutation (105) comprend un commutateur électronique et le dispositif de mesure (100) est configurée pour commuter l'élément de commutation (105) en fonction d'un signal de commande.

7. Dispositif de mesure (100) selon la revendication 6, dans lequel le dispositif de mesure (100) est configurée pour interroger une caractéristique de sécurité, en particulier un mot de passe et/ou un identifiant électronique, afin de commuter l'élément de commutation (105).

8. Dispositif de mesure (100) selon l'une des revendications précédentes, dans lequel le dispositif de mesure (100) est configurée pour communiquer via une interface Modbus et pour recevoir la spécification via le Modbus.

9. Dispositif de mesure (100) selon l'une des revendications précédentes, dans lequel l'élément de commutation (105) comprend un microcontrôleur ou un transistor, en particulier un MOSFET ou un transistor bipolaire et est configurée pour réaliser une commutation électronique.

10. Procédé de test d'un dispositif de mesure (100) avec un convertisseur A/N, le procédé comprenant :
commutation (304) d'un élément de commutation (105) afin de connecter une unité de traitement (104) du dispositif de mesure (100) à un générateur de signaux (107) du dispositif de mesure (100), le générateur de signaux (107) étant configurée pour générer un signal de test sur la base d'une spécification ;
recevoir (305) la spécification du signal de test à une entrée de commande (108) du dispositif de mesure (100) ;
délivrer (306) le signal de test par le générateur de signal (107) sur la base de la spécification à l'unité de traitement (104) ; et
traitement (307) du signal de test de sortie par l'unité de traitement (104),
délivrer en sortie la variable de sortie traitée via une interface de sortie (106) du dispositif de mesure (100) ;
dans lequel la spécification peut être lue complètement ou partiellement à partir d'une mémoire, qui est agencée en le dispositif de mesure (100), ou dans lequel la spécification provient entièrement d'une source externe,
**caractérisé en ce que**
la sortie (306) du signal de test comprend la sortie d'une indication que la sortie est basée sur un signal de test.

11. Procédé selon la revendication 10, comprenant en outre :
délivrer (308) le signal de test traité via une interface de sortie (106) du dispositif de mesure (100).

12. Procédé selon l'une quelconque des revendications 10 ou 11, dans lequel avant l'étape de commutation (304) de l'élément de commutation (105), une interrogation de sécurité est effectuée (302), et l'élément de commutation (105) n'est commuté vers le générateur de signaux (107) que si un résultat de l'interrogation de sécurité (302) est positif.

13. Procédé selon l'une quelconque des revendications 10 à 12, dans lequel un affichage pour afficher la position de commutation de l'élément de commutation (105) est émis lorsque l'élément de commutation (105) connecte le générateur de signal (107) à l'unité de traitement (104).

14. Procédé selon l'une quelconque des revendications 10 à 13, dans lequel la spécification comprend un changement d'un paramètre afin de représenter un signal erroné.
